(19) Europäisches Patentamt
European Patent Office
Office européen des brevets

(11) **EP 1 716 624 B1**

(12) **EUROPÄISCHE PATENTSCHRIFT**

(45) Veröffentlichungstag und Bekanntmachung des Hinweises auf die Patenterteilung:
**28.01.2009 Patentblatt 2009/05**

(21) Anmeldenummer: **05714918.9**

(22) Anmeldetag: **02.02.2005**

(51) Int Cl.:
**H01S 5/024** (2006.01)  **F28D 9/00** (2006.01)
**F28D 15/00** (2006.01)

(86) Internationale Anmeldenummer:
**PCT/DE2005/000163**

(87) Internationale Veröffentlichungsnummer:
**WO 2005/081371 (01.09.2005 Gazette 2005/35)**

(54) **VERFAHREN ZUM HERSTELLEN VON PLATTENSTAPELN, INSBESONDERE VON AUS PLATTENSTAPELN BESTEHENDEN KÜHLERN ODER KÜHLERELEMENTEN**

METHOD FOR THE PRODUCTION OF STACKS OF PLATES, ESPECIALLY COOLERS OR COOLER ELEMENTS COMPOSED OF STACKS OF PLATES

PROCEDE POUR REALISER DES PILES DE PLAQUES, NOTAMMENT DES RADIATEURS OU DES ELEMENTS DE REFRIGERATION COMPOSES DE PILES DE PLAQUES

(84) Benannte Vertragsstaaten:
**AT BE BG CH CY CZ DE DK EE ES FI FR GB GR HU IE IS IT LI LT LU MC NL PL PT RO SE SI SK TR**

(30) Priorität: **20.02.2004 DE 102004008836**
**12.03.2004 DE 102004012232**

(43) Veröffentlichungstag der Anmeldung:
**02.11.2006 Patentblatt 2006/44**

(73) Patentinhaber: **Electrovac AG**
**3400 Klosterneuburg (AT)**

(72) Erfinder: **SCHULZ-HARDER, Jürgen**
**91207 Lauf (DE)**

(74) Vertreter: **Graf, Helmut et al**
**Patentanwälte**
**Graf Wasmeier Glück**
**Postfach 10 08 26**
**93008 Regensburg (DE)**

(56) Entgegenhaltungen:
**EP-A- 1 136 782      EP-A- 1 271 723**
**US-B1- 6 643 302**

**Beschreibung**

Die Erfindung bezieht sich auf eine Verfahren zum Herstellen von Plattenstapeln insbesondere zum Herstellen von aus wenistens einem Plattenstapel bestehenden Kühlern oder Kühlerelementen oder Wärmesenken gemäß Obebegriff Patentanspruch 1.

Speziell zum Kühlen von elektrischen Bauteilen oder Modulen, insbesondere auch solchen mit hoher Leistung, sind bereits Kühler, auch Mikrokühler bekannt, siehe z.B EP1136782A1, die aus miteinander zu einem Stapel verbundenen dünnen Platten aus Metall (Metallfolie) bestehen und von denen die im Stapel innen liegenden Platten derart strukturiert, d.h. mit Öffnungen oder Durchbrüchen versehen sind, daß sich im Inneren des Plattenstapels bzw. Kühlers Kühlkanäle oder Strömungswege für ein Kühlmedium bilden. Zum flächigen Verbinden der Platten sind diese an ihren Fügeflächen, d.h. an ihren Oberflächenseiten mit einem Fügemittel versehen. Für das Fügen bzw. Verbinden werden die Platten dann zu dem Plattenstapel übereinander gestapelt und anschließend auf eine entsprechende Prozeßtemperatur erhitzt, bei der unter Verwendung des Fügemittels an den Fügeflächen ein schmelzflüssiger Metallbereich (Verbindungs- oder Schmelzschicht) erzeugt wird, so daß nach dem Abkühlen die Platten zu dem Plattenstapel miteinander verbunden sind.

Nachteilig bei bekannten Verfahren ist, dass insbesondere am Übergang zwischen Platten des Plattenstapels Mikrolunker verbleiben, die eine Korrosion begünstigen und dadurch zu Undichtigkeiten bei Kühlern, Heat-Pipes usw. führen können.

Aufgabe der Erfindung ist es, ein Verfahren aufzuzeigen, welches diese Nachteile vermeidet. Zur Lösung dieser Aufgabe ist ein Verfahren entsprechend dem Patentanspruch 1 ausgebildet.

Weiterbildungen der Erfindung sind Gegenstand der Unteransprüche. Die Erfindung wird im Folgenden im Zusammenhang mit den Figuren an weiteren Ausführungsbeispielen erläutert. Es zeigen:

Fig. 1      in vereinfachter perspektivischer Explosionsdarstellung fünf Platten oder Schichten aus Metall eines Kühlers zum Kühlen von elektrischen Bauelementen, insbesondere zum Kühlen von Laserdioden oder Laserdiodenbarren;

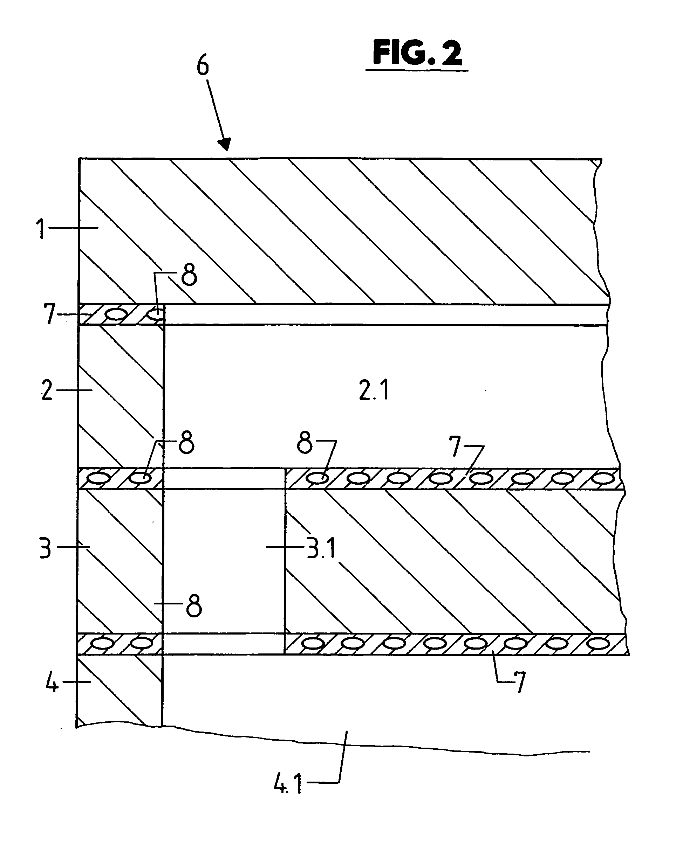

Fig. 2      in vereinfachter Darstellung einen Teilschnitt durch die aus den Platten der Figuren 1 hergestellte Wärmesenke;

Fig. 3      in vereinfachter schematischer Darstellung eine die Wärmesenke nach dem Verbinden der Platte für eine Nachbehandlung durch heißes isostatisches Pressen (HIP) aufnehmende Kammer;

Fig. 4-6    Teilschnitte durch die Platten oder Schichten aus Metall eines Kühlers.

In den Figuren sind 1 - 5 jeweils plattenförmige Elemente oder Platten aus einem Metall, beispielsweise aus Kupfer, die flächig miteinander zu einem Plattenstapel verbunden einen Kühler bzw. eine Wärmesenke 6 zum Kühlen eines nicht dargestellten elektrischen Bauelementes, beispielsweise eines Laserdiodenbarrens bilden, der eine Vielzahl von Laserlicht imitierenden Dioden aufweist. Die Platten 1 - 5 sind bei der dargestellten Ausführungsform rechteckförmige Zuschnitte gleicher Größe aus einer Metallfolie, beispielsweise Kupferfolie.

Zur Bildung einer Kühlerstruktur sowie zur Bildung von Kanälen zum Zu- und Abführen eines beispielsweise flüssigen Kühlmediums sind die Platten 2-5 strukturiert, d.h. mit entsprechenden Durchbrüchen oder Öffnungen 2.1, 3.1, 3.2, 4.1, 4.2 und 5.1, 5.2 versehen.

Unter Verwendung eines geeigneten Fügemittels, welches in den Figuren allgemein mit 7 bezeichnet ist, sowie unter Verwendung eines auf dieses Fügemittel abgestimmten Fügeverfahrens werden die zu einem Stapel übereinander angeordneten Platten unter Einwirkung von Hitze bei einer Fügetemperatur an ihren einander zugewandten Oberflächenseiten flächig miteinander verbunden, sodass dann die Öffnungen 5.1 und 5.2 die Anschlüsse zum Zu- und Abführen des Kühlmediums sowie die übrigen Öffnungen 2.1, 3.1, 3.2 einen internen, nach Außen hin abgeschlossenen Strömungskanal für das Kühlmedium bilden. Das Strukturieren der Platten 1-5 erfolgt vor dem Verbinden dieser Platten durch geeignete Techniken, beispielsweise durch Ätzen oder Stanzen.

Als Fügeverfahren eignen sich grundsätzlich alle bekannten Verfahren, die zum Verbinden der Platten 1-5 aus Metall und insbesondere auch für die Herstellung von aus Plattenstapeln bestehenden Kühlern oder Wärmesenken verwendet werden. Einzelne, derartige Verfahren werden nachstehend noch näher beschrieben. Es handelt sich bei diesen Verfahren grundsätzlich um solche, bei denen das Fügen bzw. Verbinden der Platten 1 - 5 bei einer erhöhten Temperatur (z.B. höher als 650°C) erfolgt, und zwar durch eine Lötverbindung auch im weitesten Sinne, d.h. durch Aufschmelzen einer metallischen Verbindungsschicht bzw. des Fügemittels 7 und anschließendes Abkühlen oder aber durch Diffusions-Schweißen.

Nachteilig bei den bekannten Verfahren ist unter anderem, dass sich im Bereich der Verbindung zwischen zwei benachbarten Platten 1 - 5 Ausnehmungen oder Hohlräume, d.h. sogenannte Mikrolunker 8 bilden, die teilweise geschlossen, teilweise aber auch zu den von den Öffnungen oder Durchbrüchen gebildeten Strömungskanälen hin offen sind. Diese Lunker 8 haben insbesondere den Nachteil, dass sie zu einer erhöhten Korrosion führen und es insbesondere auch bei einer Vielzahl derartiger Lunker 8 zu einer Durchkorrosion des jeweiligen Kühlers 6 im Bereich der Verbindung zwischen zwei Platten 1 - 5 und damit u.a. zu einem Undichtwerden des im Kühler ausgebildeten Strömungskanals kommen kann.

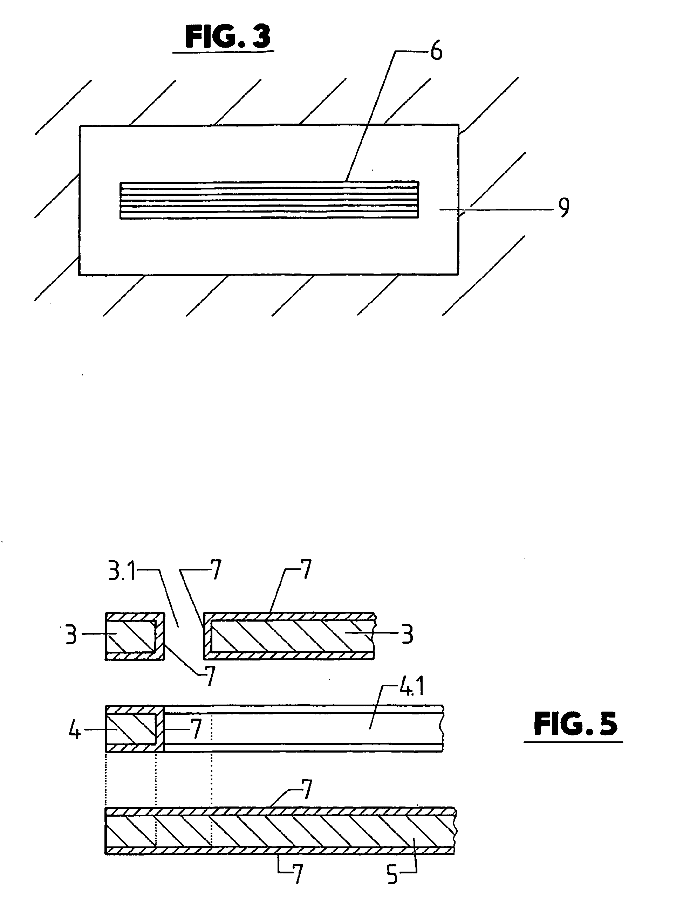

Um dies zu vermeiden, wird entsprechend der Erfindung der Kühler 6 nach seiner Herstellung, d.h. nach dem Verbinden bzw. Fügen der Platten 5 in einer Kammer 9 einer Nachbehandlung unterzogen (Figur 3), und zwar in einer Schutzgasatmosphäre bei hoher Behandlungstemperatur TB unterhalb der Fügetemperatur TF und bei hohem Gasdruck PB im Bereich zwischen 200 und 2000 bar, wobei der Gasdruck bei dieser Nachbehandlung vorzugsweise wenigstens 1000 bar beträgt. Durch diese, auch als heißes isostatisches Pressen (HIP) bezeichnete Nachbehandlung erfolgt ein Zusammendrücken der vorhandenen Mikrolunker 8 und ein nachträgliches Verbinden der Platten 1 - 5 im Bereich der bis dahin vorhandenen Mikrolunker 8 durch Diffusions-Schweißen, sodass nach Abschluss der Nach- oder HIP-Behandlung die Verbindung zwischen den Platten 1 - 5 weitestgehend lunkerfrei ist und dadurch die vorgenannten Korrosionsprobleme verhindert sind.

Als Schutzgas eignet sich z.B. Stickstoff, Argon oder andere Inert- oder Edelgase oder aber Mischungen hiervon, wobei der Sauerstoffgehalt in der Schutzgasatmosphäre in Abhängigkeit von der Temperatur TB der Nachbehandlung sowie auch in Abhängigkeit von dem für die Platten 1 - 5 verwendeten Metall derart eingestellt ist, dass keine oder keine nennenswerte und damit störende Oxidation des Metalls der Platten 1 - 5 eintritt.

Bei einer bevorzugten Ausführungsform entspricht der Sauerstoffgehalt der Schutzgasatmosphäre maximal 300 % des Gleichgewichtssauerstoffpartialdrucks des verwendeten Metalls bei der jeweiligen Behandlungstemperatur TB. Bei Verwendung von Platten aus Kupfer ergibt sich demnach ein Sauerstoffanteil bzw. Sauerstoffpartialdruck in Abhängigkeit von der Temperatur entsprechend der nachstehenden Tabelle:

| Behandlungstemperatur TB (Grad C°) | Sauerstoffpartialdruck (bar) |
|---|---|
| 1.085 | $1,2 \times 10^{-5}$ |
| 1.027 | $3,3 \times 10^{-6}$ |
| 927 | $2,43 \times 10^{-7}$ |
| 827 | $3,9 \times 10^{-8}$ |
| 727 | $1,0 \times 10^{-9}$ |
| 627 | $1,1 \times 10^{-11}$ |
| 527 | $4,1 \times 10^{-13}$ |
| 427 | $2,8 \times 10^{-16}$ |
| 327 | $1,7 \times 10^{-20}$ |

Bei der Nachbehandlung ist es also erforderlich, eine Oxidation oder andere Reaktion des Materials des Kühlers mit dem Druckgas zu vermeiden. In Systemen, in denen als Material für die Platten 1 - 5 und/oder für das Fügemittel 7 Kupfer, Kupfer in Verbindung mit Sauerstoff, Silber oder Gold verwendet ist, eignet sich als Druckgas bzw. Inertgas, Stickstoff. In anderen Systemen, in denen z.B. Eisen und/oder Aluminium verwendet ist, ist allerdings Stickstoff als Druckgas wegen der Nitridbildung nicht geeignet. Als Schutzgas wird dann Argon eingesetzt. Ebenso wie Stickstoff oder Argon enthalten auch andere, als Druckgas verwendbare technische Gase stets Sauerstoff in geringen Mengen. Um bei der Nachbehandlung eine Oxidation oder andere Reaktion mit dem Kühler 6 zu vermeiden, ist bei den in der Tabelle angeggebenen Werten darauf geachtet, dass der Gehalt an Sauerstoff nicht zu weit über dem Gleichgewichtssauerstoffpartialdruck des Systems Metall-Sauterstoff liegt. Allerdings ist ein Sauerstoffgehalt, der einer Überschreitung des GleichgewichtsSauerstoffpartialdruckes zwischen 200 und 300 % entspricht, noch zulässig, da insbesondere auch bei einer nicht all zu hohen Nachbehandlungstemperatur TB die Reaktion des für den Kühler 6 verwendeten Metalls mit Sauerstoff, d.h. die Oxidbildung genetisch gehemmt ist und außerdem eine geringfügige Oxidschicht in der Regel nicht störend ist. Bei Öfen mit Graphit besteht dieses Problem ohnehin nicht.

Die Behandlungstemperatur TB ist so eingestellt, dass bei der Nachbehandlung die Fügeverbindung zwischen den Platten 1-5 erhalten bleibt, d.h. die Behandlungstemperatur TB ist möglichst hoch gewählt, um das vorgenannte Diffusions-Schweißen zum Entfernen der Mikrolunkern 8 zu erreichen, liegt aber unterhalb der Temperatur TF bei der nach dem Fügen das gesamte Fügemittel 7, d.h. das gesamte, beim Fügen der Platten 1-5 zwischen diesen Platten das Fügemittel 7 bildende metallische System und damit sämtliche Bestandteile dieses Systems gerade in den festen Zustand übergegangen sind, d.h. die Solidus-Temperatur des Fügemittelsystems erreicht ist. Bei einer bevorzugten Ausführungsform der Erfindung beträgt die Behandlungstemperatur TB etwa 50 bis 99% der Temperatur TF in °K.

Für die Nachbehandlung des Kühlers 6 wird dieser nach dem Fügen und Abkühlen beispielsweise auf eine Temperatur, die ein bequemes Handling des Kühlers 6 ermöglichst, in die Kammer 9 eingebracht und in dieser Kammer dann durch erneutes Erhitzen auf die Behandlungstemperatur TB gebracht und auf bei dem Nachbehandlungsdruck PB in der Kammer 9 über eine Nachbehandlungszeit beispielsweise zwischen 15 und 45 Minuten gehalten.

Grundsätzlich besteht aber bei einer entsprechenden Ausbildung der für die Produktion verwendeten Einrichtungen auch die Möglichkeit, die Nachbehandlung unmittelbar nach dem Fügen vorzunehmen, und zwar sobald die Temperatur des hergestellten Kühlers 6 die Behandlungstemperatur TB erreicht hat.

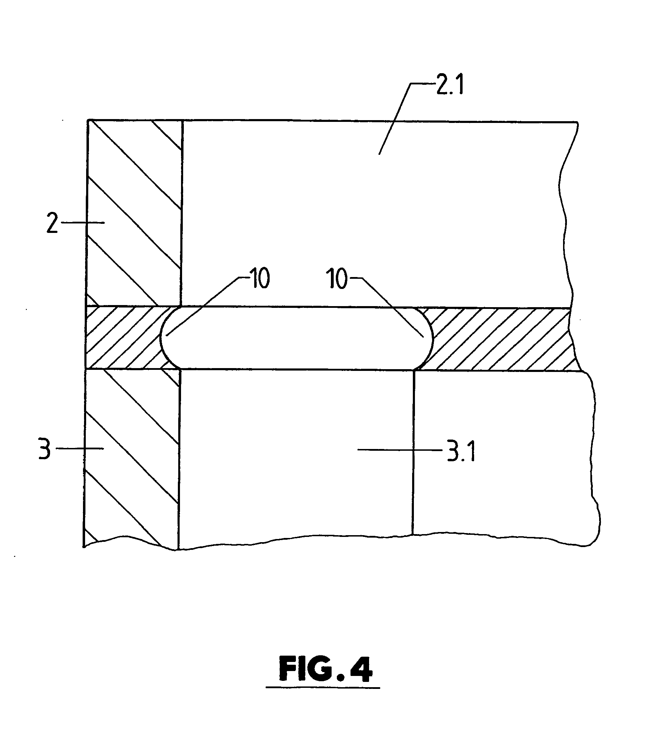

Wie oben ausgeführt, sind verschiedene Fügeverfahren bzw. Techniken und diesem Verfahren entsprechende Fügemittel 7 zur Herstellung des Kühlers 6 denkbar. Hierbei ist es möglich, die einzelnen Platten 1 - 5 vor dem Verbinden bzw. Fügen nur an ihren Oberflächenseiten und dabei beispielsweise nur an ihrem miteinander zu verbindenden Oberflächenseiten mit dem Fügemittel zu versehen. Dies hat allerdings entsprechend der Figur 4 den Nachteil, dass an den Übergängen zwischen zwei Platten im Bereich des Fügemittels 7 sich Toträume 10 ausbilden, wie dies in der Figur 4 im Bereich des Übergangs zwischen den Platten 2 und 3 und im Bereich der dortigen Öffnungen 2.1 und 3.1 nochmals vergrößert dargestellt sind. Auch diese Toträume 10 haben erhebliche Nachteile, d.h. sie führen zu unerwünschten Verwirbelungen des den Kühler 6 durchströmenden Kühlmediums, insbesondere führen diese Toträume 10 aber zu unerwünschten Korrosionen, speziell auch an den durch die Toträume 10 freiliegenden Rändern oder Kanten der Öffnungen 2.1 und 3.1.

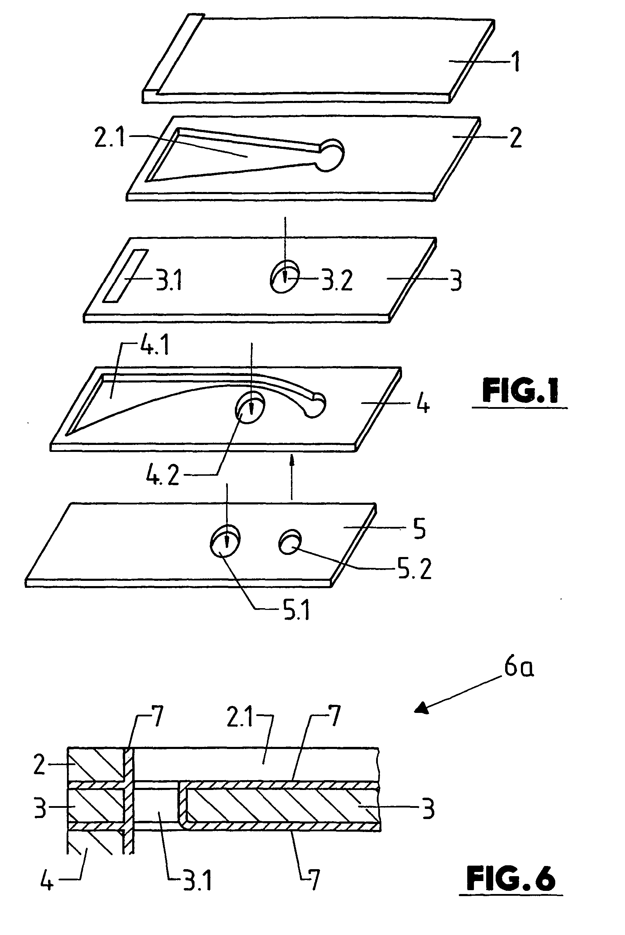

Um die Toträume 10 zu vermeiden, kann es daher entsprechend der Figur 5 zumindest zweckmäßig sein, die Platten 1 - 5 nicht nur an ihren Oberflächenseiten, sondern auch an den Begrenzungsflächen der Öffnungen mit dem Fügemittel 7 zu versehen, sodass dann nach dem Fügen der Platten 1 - 5 sämtliche Flächen und Kanten, insbesondere auch die von den Seitenflächen der Öffnungen gebildeten Flächen und Kanten der Kanäle des Kühlers 6 mit dem Fügemittel 7 abgedeckt, wie dies in der Figur 6 für den Kühler 6a dargestellt ist. Die nachteiligen Toträume 10 sind dabei vermieden. Durch die Nachbehandlung bzw. durch das heiße isostatische Pressen bzw. Hippen werden auch eventuelle Mikrolunker 8 auch in dem die Kanäle des Kühlers 6a abdeckenden Fügemittel vermieden.

Vorstehend wurde davon ausgegangen, daß zur Herstellung des Kühlers 6a sämtliche Platten 1 - 5 zumindest an ihren, miteinander zu verbindenden Oberflächenseiten sowie auch an den Innenflächen der Durchbrüche mit dem Fügemittel 7 versehen werden. Grundsätzlich ist es auch ausreichend, nur bei einigen der Platten 1 - 5 die innenflächen der dortigen Durchbrüche mit dem Fügemittel 7 vor dem Fügen zu beschichten.

Das Fügen der z.B. aus Kupfer bestehenden Platten 1 - 5 erfolgt beispielsweise durch die DCB-Technik (Direct Copper Bonding), wobei als Fügemittel Kupfer-Oxid verwendet ist, welches in Verbindung mit dem angrenzenden Kupfer der Platten 1 - 5 ein Eutektikum bzw. eine eutektische Verbindungs- oder Schmelzschicht mit einem Schmelzpunkt im Bereich zwischen etwa 1065°C - 1082°C bildet. Dementsprechend liegt dann die maximale Behandlungstemperatur bei TBmax = [0,99 (1065 + 273) - 273]°C = 1052°C. Für die minimale Behandlungstemperatur $TB_{min}$ ergibt sich dann $TB_{min}$ = [0,5 (1065 + 273) - 273]°C =396°C.

Wird als Fügemittel 7 ein Hartlot verwendet, beispielsweise eine Kupfer-SilberLegierung, deren eutektische Temperatur bzw. Fügetemperatur bei etwa 768°C liegt, so ergeben sich für die Behandlungstemperatur

$$TB_{max} = [0,99(768 + 273)-273]°C = 746°C$$

$$TB_{min} = [0,50(768 + 273)-273]°C = 377°C$$

Wird als Fügemittel ein Hartlot in Form einer Legierung aus Kupfer und Gold verwendet, welches eine eutektische Temperatur bzw. Fügetemperatur von etwa 889°C aufweist, so ergeben sich für die Behandlungstemperatur

$$TB_{max} = [0,99(889 + 273)-273]°C = 877,5°C$$

$$TB_{min} = [0,50(889 + 273)-273]°C = 308°C$$

Aufgrund der jeweils verwendeten Menge an Fügemittel 7 oder an Lot und aufgrund der verwendeten Prozesstemperatur und/oder Prozesszeit während des Fügevorgangs können an den Übergängen zwischen den Platten diese metallisch miteinander verbindende Legierungen auftreten, deren Fügetemperatur TF höher liegt als die ursprüngliche eutektische Temperatur des Fügemittels, sodass die Temperatur TB auch entsprechend höher gewählt werden kann.

Die Erfindung wird nachstehend an einigen Beispielen beschrieben.

Beispiel 1

Bei diesem Beispiel wird als Fügemittel Kupfer-Oxid verwendet. Zum Herstellen des Kühlers 6 bzw. 6a werden durch Ätzen oder Stanzen die Platten 1 - 5 mit ihren Durchbrüchen und Öffnungen hergestellt. Anschließend werden die Platten an ihren Oberflächenseiten, bevorzugt aber auch an den Innenflächen der Durchbrüche mit dem Fügemittel 7 versehen, und zwar durch Oxidieren.

Die Platten 1-5 werden dann gestapelt und es erfolgt ein Erhitzen des Stapels auf die erforderliche Prozesstemperatur, beispielsweise von etwa 1075°C in einer Schutzgasatmosphäre mit einem Sauerstoffanteil von 2,5 bis 100 ppm.

Anschließend wird der Stapel aus den nunmehr miteinander flächig verbundenen Platten 1 - 5 auf eine Temperatur unterhalb der Prozesstemperatur, z.B. auf Raumtemperatur abgekühlt. Der so hergestellte Kühler 6 bzw. 6a wird dann in der Kammer 9 bei einem Schutzgasdruck von etwa 1000 bar auf eine Temperatur von etwa 1020°C erhitzt und bei dieser Temperatur und diesem Druck über eine Zeit von 30 Minuten gehalten. Anschließend erfolgt ein Abkühlen auf Raumtemperatur.

Beispiel 2

Bei diesem Beispiel wird als Fügemittel Silber verwendet, welches bei der Fügetemperatur zusammen mit dem angrenzenden Kupfer der Platten 1 - 5 ein eutektisches Lot aus Silber und Kupfer bildet.

Es folgt wiederum die Herstellung der Platten 1 - 5 mit ihren Durchbrüchen durch Stanzen und Ätzen. Anschließend wir galvanisch und/oder chemisch auf die Platten 1-5 und dabei zumindest auf die miteinander zu verbindenden Oberflächenseiten dieser Platten, bevorzugt aber auch zumindest bei einigen der Platten auf die Begrenzungsflächen der Durchbrüche eine Silberschicht, beispielsweise mit einer Dicke von 3 $\mu$m aufgebracht.

Die so behandelten Platten 1-5 werden dann gestapelt und der Plattenstapel wird in einer Schutzgasatmosphäre, beispielsweise in einer Stickstoffatmosphäre mit einem Sauerstoffanteil kleiner als 100 ppm und bei einer Prozess- oder Fügetemperatur TF von 850°C erhitzt. Anschliessend erfolgt ein Abkühlen des Plattenstapels bzw. des als Plattenstapel hergestellten Kühlers auf Raumtemperatur.

Der Plattenstapel wird dann in die Kammer 9 eingebracht und dort in einer Schutzgasatmosphäre, beispielsweise in einer Stickstoffatmosphäre bei einem Nachbehandlungsdruck PB von etwa 1200 bar auf TB von 650°C erhitzt und bei diesem Druck und dieser Nachbehandlungstemperatur TB über eine Zeit von etwa 45 Minuten gehalten. Anschliessend erfolgt ein Abkühlen auf Raumtemperatur.

Beispiel 3

Bei diesem Verfahren wird als Fügemittel Gold verwendet, welches zusammen mit dem Kupfer der Platten 1 - 5 ein eutektisches Lot bildet. Es erfolgt wiederum die Herstellung der Platten 1 - 5 mit ihren Durchbrüchen und ein anschliessendes Auftragen einer Goldschicht mit einer Dicke von etwa 2 $\mu$m auf die Platten 1-5 sowie auch auf die Begrenzungsflächen zumindest einiger Ausnehmungen oder Durchbrüche.

Die übereinander gestapelten Platten werden dann in einer beispielsweise von Stickstoff gebildeten Schutzgasatmosphäre mit einem Sauerstoffanteil kleiner als 100 ppm auf 1030°C erhitzt. Anschließend erfolgt ein Abkühlen und Einbringen des Plattenstapels bzw. Kühlers 6 oder 6a in die Kammer 9 und nach dem Verschliessen der Kammer in einer von Argon gebildeten Schutzgasatmosphäre die Nachbehandlung bei einem Druck von etwa 900 bar und einer Temperatur TB von etwa 920°C, und zwar über eine Behandlungsdauer von etwa 30 Minuten und im Anschluss daran ein Abkühlen auf Raumtemperatur.

Die Erfindung wurde voranstehend an Ausführungsbeispielen beschrieben. Es versteht sich, dass zahlreiche Änderungen sowie Abwandlungen möglich sind.

**Bezugszeichenliste**

| | |
|---|---|
| 1-5 | Platte |
| 6, 6a | Kühler |
| 7 | Fügematerial |
| 8 | Mikrolunker |

| 9 | Kammer |
| 10 | Totraum* |
| 2.1, 3.1, 3.2, 4.1, 5.1, 5.2 | Öffnung oder Durchbruch |

**Patentansprüche**

1. Verfahren zum Herstellen von Plattenstapeln, insbesondere zum Herstellen von aus wenigstens einem Plattenstapel bestehenden Kühlern, Kühlelementen oder Wärmesenken (6, 6a) zum Kühlen von elektrischen und/oder opto-elektrischen Bauteilen, wobei das Verfahren zumindest folgende Prozess-Schritte aufweist: Herstellen von Platten oder Platinen (1 - 5) aus Metall, beispielsweise Kupfer, Stapeln der Platten zu einem Plattenstapel, Verbinden oder Fügen der Platten (1 - 5) unter Temperatureinwirkung bei einer Fügetemperatur (TF) und bei atmosphärischem Druck oder im Vakuum, Abkühlen des von den verbundenen Platten gebildeten Plattenstapels auf eine Temperatur kleiner als die Fügetemperatur (TF) und **gekennzeichnet durch** Nachbehandeln (HIP-Nachbehandeln) des Plattenstapels in einer Schutzgasatmosphäre bei einem Schutzgasdruck (PB) im Bereich zwischen 200 und 2000 bar, beispielsweise im Bereich zwischen 400 und 2000 bar und bei einer Nachbehandlungstemperatur (TB), die kleiner ist als die Fügetemperatur (TF).

2. Verfahren nach Anspruch 1, **dadurch gekennzeichnet, dass** die Nachbehandlungstemperatur (TB) etwa maximal 95 bis 99% der Fügetemperatur (TF) beträgt.

3. Verfahren nach Anspruch 1 oder 2, **dadurch gekennzeichnet, dass** die Nachbehandlungstemperatur (TB) wenigstens 50% der Fügetemperatur (TF) beträgt.

4. Verfahren nach einem der vorhergehenden Ansprüche, **gekennzeichnet durch** ein Nachbehandeln des Plattenstapels in einer Schutzgasatmosphäre bei einem Gasdruck im Bereich zwischen etwa 200 bis 2000 bar, beispielsweise im Bereich zwischen 400 und 2000 bar und bei einer Behandlungstemperatur(TB), die etwa 50

   - 99 % oder 50 - 95% der Fügetemperatur (TF) entspricht, d.h. derjenigen Temperatur entspricht, bei dem sämtliche metallischen Bestandteile des die Fügeverbindung bildenden Systems in den festen Zustand übergegangen sind.

5. Verfahren nach einem der vorhergehenden Ansprüche, **gekennzeichnet durch** ein Nachbehandeln des Plattenstapels in einer Schutzgasatmosphäre bei einem Gasdruck im Bereich zwischen etwa 200 bis 2000 bar, beispielsweise im Bereich zwischen 400 und 2000 bar und bei einer Behandlungstemperatur(TB), die etwa 50 - 99 % oder 50 - 95% der Fügetemperatur (TF) entspricht, d.h. derjenigen Temperatur entspricht, bei dem sämtliche Bestandteile des die Fügeverbindung bildenden Lotes in den festen Zustand übergegangen sind.

6. Verfahren nach einem der vorhergehenden Ansprüche, **dadurch gekennzeichnet, dass** zumindest auf die miteinander zu verbindenden Oberflächenseiten der Platten ein Fügemittel (7) aufgebracht wird.

7. Verfahren nach einem der vorhergehenden Ansprüche, **gekennzeichnet durch** folgende Verfahrensschritte Aufbringen eines Lotes als Fügemittel auf die Platten, Stapeln der Platten zu dem Plattenstapel, Erhitzen des Plattenstapels zumindest auf die Schmelztemperatur des Lotes, Abkühlen des Plattenstapels auf eine Temperatur unterhalb der Schmelztemperatur des Lotes, HIP-Nachbehandeln des Plattenstapels.

8. Verfahren nach einem der vorhergehenden Ansprüche, **dadurch gekennzeichnet, dass** beim HIP-Nachbehandeln eine Schutzgasatmosphäre, beispielsweise eine von Argon oder Stickstoff gebildete Schutzgasatmosphäre mit einem maximalen Sauerstoffgehalt verwendet wird, der etwa 300 % des dem Gleichgewichtssauerstoffpartialdruckes bei der Behandlungstemperatur (TB) entsprechenden Sauerstoffgehalt beträgt.

9. Verfahren nach Anspruch 8, **dadurch gekennzeichnet, dass** der Anteil an Sauerstoff in der Schutzgasatmosphäre kleiner ist als ein Sauerstoffpartialdruck von $15 \times 10^{-6}$ bar.

10. Verfahren nach einem der vorhergehenden Ansprüche, **gekennzeichnet durch** folgende Verfahrensschritte

**EP 1 716 624 B1**

Aufbringen oder Erzeugen einer Kupfer-Oxyd-Schicht als Fügemittel auf den aus Kupfer bestehenden Platten, Erhitzen der Platten nach dem Stapel auf eine Temperatur im Bereich zwischen 1065 und 1083°C und HIP-Nachbehandeln des Plattenstapels bei einem Druck im Bereich zwischen 200 und 2000 bar, beispielsweise 400 und 2000 bar bei einer Nachbehandlungstemperatur von mindestens 390°C und maximal 1052°C.

11. Verfahren nach einem der vorhergehenden Ansprüche, **gekennzeichnet durch** folgende Verfahrensschritte Aufbringen oder Erzeugen einer Kupfer-Oxyd-Schicht als Fügemittel auf den aus Kupfer bestehenden Platten, Erhitzen der Platten nach dem Stapel auf eine Temperatur von 1065 °C und HIP-Nachbehandeln des Plattenstapels bei einem Druck von 1000 bar bei einer Nachbehandlungstemperatur von 1020°C.

12. Verfahren nach einem der vorhergehenden Ansprüche, **dadurch gekennzeichnet,**
    **dass** das Fügen der Platten (1-5) unter Hitzeeinwirkung bei einem mechanischen Pressdruck im Bereich zwischen 20 und 2500 bar erfolgt.

13. Verfahren nach einem der vorhergehenden Ansprüche, **dadurch gekennzeichnet,**
    **dass** die Platten aus Kupfer bestehen, und dass als Fügemittel Silber verwendet ist, welches zusammen mit dem angrenzenden Kupfer ein Silber-Kupfer-Lot bildet, dass der Plattenstapel zum Fügen auf eine Temperatur im Bereich zwischen 778 und 990°C erhitzt wird, und dass die HIP-Nachbehandlung bei einem Druck von 400 bis 2000 bar bei einer Nachbehandlungstemperatur von wenigstens 252°C und maximal 767°C, beispielsweise bei 650°C erfolgt.

14. Verfahren nach einem der vorhergehenden Ansprüche, **dadurch gekennzeichnet,**
    **dass** die Platten aus Kupfer bestehen, und dass als Fügemittel Silber verwendet ist, welches zusammen mit dem angrenzenden Kupfer ein Silber-Kupfer-Lot bildet, dass der Plattenstapel zum Fügen auf eine Temperatur von 850°C erhitzt wird, und dass die HIP-Nachbehandlung bei einem Druck von 1200 bar bei einer Nachbehandlungstemperatur von 650°C erfolgt.

15. Verfahren nach einem der vorhergehenden Ansprüche, **gekennzeichnet durch** folgende Verfahrensschritte Verwendung von Platten aus Kupfer und Gold oder eine Gold-Kupfer-Legierung als Fügemittel Erhitzen des Plattenstapels auf eine Temperatur im Bereich zwischen 880 und 1065°C Nachbehandlung des Plattenstapels bei einer Temperatur von wenigstens 408°C und maximal 877°C.

16. Verfahren nach einem der vorhergehenden Ansprüche, **gekennzeichnet durch** folgende Verfahrensschritte Verwendung von Platten aus Kupfer und Gold oder eine Gold-Kupfer-Legierung als Fügemittel Erhitzen des Plattenstapels auf eine Temperatur von 1030°C HIP-Nachbehandlung des Plattenstapels bei einer Temperatur von 920°C und einem Druck (PB) von 900 bar.

17. Verfahren nach einem der vorhergehenden Ansprüche, **dadurch gekennzeichnet,**
    **dass** auf den Plattenstapel oder auf den von dem Plattenstapel gebildeten Kühler (6, 6a) wenigstens ein elektrisches Bauelement, beispielsweise durch Auflöten befestigt wird, wobei das Bauelement z.B. eine Laserdiode oder eine Leuchtdiode ist.

18. Verfahren nach einem der vorhergehenden Ansprüche, **dadurch gekennzeichnet,**
    **dass** das Fügemittel (7) auch auf Flächen wenigstens einiger Durchbrüche aufgetragen wird.

19. Verfahren nach einem der vorhergehenden Ansprüche, **dadurch gekennzeichnet,**
    **dass** der Plattenstapel oder der von diesem gebildete Kühler (6, 6a) an wenigstens einer Oberfläche durch Diamantfräsen bearbeitet wird.

**Claims**

1. Method for manufacturing plate stacks, more particularly for manufacturing coolers, cooler elements or heat sinks (6,6a), consisting of at least one plate stack, for cooling electrical and/or opto-electrical components wherein the method comprises at least the following processing steps:

   manufacturing plates or blanks (1-5) of metal, by way of example copper, stacking the plates into a plate stack, connecting or joining the plates (1-5) through the effect of temperature at a joining temperature (TF) and at atmospheric pressure or in a vacuum,

cooling the plate stack formed from the interconnected plates to a temperature lower than the joining temperature (TF) and **characterised by** after treatment (HIP after treatment) of the plate stack in a protective gas atmosphere at a protective gas pressure (PB) in the region of between 200 and 2000 bar, by way of example in the region of between 400 and 2000 bar and at an after treatment temperature (TB) which is lower than the joining temperature (TF).

2. Method according to claim 1 **characterised in that** the after treatment temperature (TB) is approximately a maximum of 95 to 99% of the joining temperature (TF).

3. Method according to claim 1 or 2 **characterised in that** the after treatment temperature (TB) is at least 50% of the joining temperature (TF).

4. Method according to one of the preceding claims **characterised by** an after treatment of the plate stack in a protective gas atmosphere at a gas pressure in the region of between about 200 and 2000 bar, by way of example in the region of between 400 and 2000 bar and at a treatment temperature (TB) which corresponds to about 50 - 99 % or 50 - 95% of the joining temperature (TF) , i.e. corresponds to that temperature at which all the metal constituent parts of the system forming the seamless connection have changed into the solid state.

5. Method according to one of the preceding claims **characterised by** an after treatment of the plate stack in a protective gas atmosphere at a gas pressure in the region of between about 200 and 2000 bar, by way of example in the region of between 400 and 2000 bar and at a treatment temperature (TB) which corresponds to about 50 - 99% or 50 - 95% of the joining temperature (TF), i.e. corresponds to that temperature at which all the constituent parts of the solder forming the seamless connection have changed into the solid state.

6. Method according to one of the preceding claims **characterised in that** a joining agent (7) is applied at least to the surfaces of the plates which are to be connected together.

7. Method according to one of the preceding claims **characterised by** the following method steps:

    applying a solder as joining means onto the plates,
    stacking the plates into a plate stack,
    heating the plate stack at least to the melting temperature of the solder, cooling the plate stack down to a temperature below the melting temperature of the solder,
    HIP after treatment of the plate stack.

8. Method according to one of the preceding claims **characterised in that** during the HIP after treatment a protective gas atmosphere is used, by way of example a protective gas atmosphere formed by argon or nitrogen having a maximum oxygen content which amounts to approximately 300% of the oxygen content corresponding to the balanced oxygen partial pressure at the treatment temperature (TB).

9. Method according to claim 8 **characterised in that** the proportion of oxygen in the protective gas atmosphere is less than an oxygen partial pressure of $15 \times 10^{-6}$ bar.

10. Method according to one of the preceding claims **characterised by** the following method steps:

    applying or creating a copper-oxide layer as joining means on the plates which are made from copper,
    heating the plates after stacking to a temperature in the region of between 1065 and 1083°C and
    HIP after treatment of the plate stack at a pressure in the region of between 200 and 2000 bar, by way of example 400 and 2000 bar at an after treatment temperature of at least 390°C and a maximum 1052°C.

11. Method according to one of the preceding claims **characterised by** the following method steps:

    applying or creating a copper oxide layer as joining means on the plates which are made from copper,
    heating the plates after stacking to a temperature of 1065°C and
    an HIP after treatment of the plate stack at a pressure of 1000 bar at an after treatment temperature of 1020°C.

12. Method according to one of the preceding claims **characterised in that** the joining of the plates (1-5) takes place through the action of heat at a mechanical pressing pressure in the region of between 20 and 2500 bar.

**13.** Method according to one of the preceding claims **characterised in that** the plates are made from copper, and that silver is used as the joining means which together with the adjoining copper forms a silver-copper solder, that the plate stack is heated for joining to a temperature in the region of between 778 and 990°C, and that the HIP after treatment takes place at a pressure of 400 to 2000 bar at an after treatment temperature of at least 252°C and a maximum of 767°C, by way of example at 650°C.

**14.** Method according to one of the preceding claims **characterised in that** the plates are made from copper, and that silver is used as the joining means which together with the adjoining copper forms a silver-copper solder, that the plate stack is heated for joining to a temperature of 850°C, and that the HIP after treatment takes place at a pressure of 1200 bar at an after treatment temperature of 650°C.

**15.** Method according to one of the preceding claims **characterised by** the following method steps:

use of plates made of copper and gold or a gold-copper alloy as the joining means,
heating the plate stack to a temperature in the region of between 680 and 1065°C,
after treatment of the plate stack at a temperature of at least 408°C and maximum 877°C.

**16.** Method according to one of the preceding claims **characterised by** the following method steps:

use of plates of copper and gold or a gold-copper alloy as joining means,
heating the plate stack to a temperature of 1030°C,
HIP after treatment of the plate stack at a temperature of 920°C and a pressure (PB) of 900 bar.

**17.** Method according to one of the preceding claims **characterised in that** at least one electrical component is fixed, by way of example by soldering, onto the plate stack or onto the cooler (6, 6a) formed by the plate stack, wherein the component is for example a laser diode or a light diode.

**18.** Method according to one of the preceding claims, **characterised in that** the joining means (7) is also applied to surfaces of at least some apertures.

**19.** Method according to one of the preceding claims **characterised in that** the plate stack or the cooler (6, 6a) formed by same is machined on at least one surface by a diamond milling cutter.

## Revendications

**1.** Procédé de fabrication de pile de plaques, en particulier pour la fabrication de radiateurs, d'éléments réfrigérants ou de puits de chaleur (6, 6a) constitués au minimum d'une pile de plaques pour le refroidissement de composants électriques et/ou optoélectriques, le procédé comportant au moins les étapes de procédé ci-dessous consistant à :

fabriquer des plaques ou des platines (1 à 5) en métal, par exemple en cuivre,
empiler les plaques pour former une pile de plaques,
relier ou assembler les plaques (1 à 5) sous l'action de la chaleur à une température d'assemblage (TF) et à pression atmosphérique ou sous vide,
refroidir la pile de plaques constituée des plaques reliées à une température inférieure à la température d'assemblage (TF) et
**caractérisé par** un retraitement (retraitement HIP) (Hot Isostatic Pressing = Compression Isostatique à Chaud) de la pile de plaques en atmosphère de gaz protecteur avec une pression de gaz protecteur (PB) dans la plage comprise entre 200 et 2000 bars, par exemple dans la plage comprise entre 400 et 2000 bars et à une température de retraitement (TB) inférieure à la température d'assemblage (TF).

**2.** Procédé selon la revendication 1,
**caractérisé en ce que**
la température de retraitement (TB) est au plus de 95 à 99 % de la température d'assemblage (TF).

**3.** Procédé selon la revendication 1 ou 2,
**caractérisé en ce que**
la température de retraitement (TB) est d'au moins 50 % de la température d'assemblage (TF).

**4.** Procédé selon l'une quelconque des revendications précédentes, **caractérisé par** un retraitement de la pile de plaques sous atmosphère de gaz protecteur avec une pression de gaz située dans la plage comprise entre environ 200 et 2000 bars, par exemple dans la plage comprise entre 400 et 2000 bars et à une température de traitement (TB) correspondant à environ 50 à 99 % ou 50 à 95 % de la température d'assemblage (TF), c'est-à-dire correspondant à la température à laquelle l'ensemble des pièces métalliques du système formant la liaison assemblée passe à l'état solide.

**5.** Procédé selon l'une quelconque des revendications précédentes, **caractérisé par** un retraitement de la pile de plaques sous atmosphère de gaz protecteur avec une pression de gaz située dans la plage comprise entre environ 200 et 2000 bars, par exemple dans la plage comprise entre 400 et 2000 bars et à une température de traitement (TB) correspondant à environ 50 à 99 % ou 50 à 95 % de la température d'assemblage (TF), c'est-à-dire température correspondant à la température à laquelle l'ensemble des composants de la brasure formant la liaison assemblée passe à l'état solide.

**6.** Procédé selon l'une quelconque des revendications précédentes, **caractérisé en ce qu'**un moyen d'assemblage (7) est appliqué au moins sur les côtés de surface à relier des plaques.

**7.** Procédé selon l'une quelconque des revendications précédentes, **caractérisé par** les étapes de procédé ci-dessous consistant à :

   appliquer une brasure en tant que moyen d'assemblage sur les plaques,
   empiler les plaques pour former la pile de plaques,
   chauffer la pile de plaques au moins jusqu'à la température de fusion de la brasure,
   refroidir la pile de plaques à une température inférieure à la température de fusion de la brasure,
   procéder à un retraitement HIP de la pile de plaques.

**8.** Procédé selon l'une quelconque des revendications précédentes, **caractérisé en ce qu'**une atmosphère de gaz protecteur est utilisée lors du retraitement HIP, par exemple une atmosphère de gaz protecteur formée d'argon ou d'azote avec une teneur maximale en oxygène qui représente environ 300 % de la teneur en oxygène correspondant à la pression partielle d'oxygène d'équilibre à température de traitement (TB).

**9.** Procédé selon la revendication 8,
**caractérisé en ce que** la part en oxygène dans l'atmosphère de gaz protecteur est inférieure à une pression partielle d'oxygène de $15 \times 10^{-6}$ bars.

**10.** Procédé selon l'une quelconque des revendications précédentes, **caractérisé par** les étapes de procédé ci-dessous consistant à :

   appliquer ou produire une couche d'oxyde de cuivre en tant que moyen d'assemblage sur les plaques constituées de cuivre,
   chauffer les plaques formant la pile à une température située dans la plage comprise entre 1065 et 1083°C, et procéder au retraitement HIP de la pile de plaques à une pression située dans la plage comprise entre 200 et 2000 bars, par exemple entre 400 et 2000 bars à une température de retraitement d'au moins 390°C et au plus 1052°C.

**11.** Procédé selon l'une quelconque des revendications précédentes, **caractérisé par** les étapes de procédé ci-dessous consistant à :

   appliquer ou produire une couche d'oxyde de cuivre en tant que moyen d'assemblage sur les plaques constituées de cuivre,
   chauffer les plaques formant la pile à une température de 1065°C et procéder à un retraitement HIP de la pile de plaques à une pression de 1000 bars pour une température de retraitement de 1020°C.

**12.** Procédé selon l'une quelconque des revendications précédentes, **caractérisé en ce que** l'assemblage des plaques (1 à 5) sous l'action de la chaleur intervient avec une pression de compression mécanique située dans la plage comprise entre 20 et 2500 bars.

**13.** Procédé selon l'une quelconque des revendications précédentes, **caractérisé en ce que** les plaques sont constituées de cuivre, de l'argent est utilisé en tant que moyen d'assemblage, formant, en commun avec le cuivre adjacent, une brasure cuivre-argent, la pile de plaques est chauffée pour assemblage à une température située dans la plage comprise entre 778 et 990°C, et le retraitement HIP intervient à une pression de 400 à 2000 bars pour une température de retraitement d'au moins 252°C et au plus 767°C, par exemple à 650°C.

14. Procédé selon l'une quelconque des revendications précédentes, **caractérisé en ce que** les plaques sont constituées de cuivre, de l'argent est utilisé en tant que moyen d'assemblage, formant, en commun avec le cuivre adjacent, une brasure cuivre-argent, la pile de plaques est chauffée pour assemblage à une température de 850°C, et le retraitement HIP intervient à une pression de 1200 bars pour une température de retraitement de 650°C.

15. Procédé selon l'une quelconque des revendications précédentes, **caractérisé par** les étapes de procédé ci-dessous consistant à :

utiliser des plaques en cuivre et en or ou un alliage or-cuivre en tant que moyen d'assemblage
chauffer la pile de plaques à une température située dans la plage comprise entre 880 et 1065°C
retraiter la pile de plaques à une température d'au moins 408°C et au plus 877°C.

16. Procédé selon l'une quelconque des revendications précédentes, **caractérisé par** les étapes de procédé ci-dessous consistant à :

utiliser des plaques en cuivre et or ou un alliage or-cuivre en tant que moyen d'assemblage
chauffer la pile de plaques à une température de 1030°C,
procéder à un retraitement HIP de la pile de plaques à une température de 920°C et une pression (PB) de 900 bars.

17. Procédé selon l'une quelconque des revendications précédentes, **caractérisé en ce qu'**au moins un composant électrique est fixé, par exemple par soudage, sur la pile de plaques, ou le radiateur formé par la pile de plaques (6, 6a), ce composant étant par exemple une diode laser ou une diode électroluminescente.

18. Procédé selon l'une quelconque des revendications précédentes, **caractérisé en ce que** le moyen d'assemblage (7) est également appliqué sur des surfaces d'au moins quelques passages perforés.

19. Procédé selon l'une quelconque des revendications précédentes, **caractérisé en ce que** la pile de plaques, ou le radiateur formé par celle-ci, (6, 6a) est usiné(e) au niveau d'au moins une surface par fraisage au diamant.

1

2.1 — 2

3.1 — 3.2 — 3

FIG.1

4.1

4.2

4

5

5.2

5.1

6a

7          2.1          7

2 — 

3 — 

7     — 3

4 —

3.1          7

FIG.6

# FIG. 2

## FIG. 3

## FIG. 5

**FIG.4**

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- EP 1136782 A1